# EUROPÄISCHE PATENTSCHRIFT

(11) **EP 0 242 655 B1**
(45) Veröffentlichungstag und Bekanntmachung des Hinweises auf die Patenterteilung: **03.11.1993**
(21) Anmeldenummer: 87104852.6
(22) Anmeldetag: 02.04.1987
(51) Int. Cl.: G03F 3/10

(54) **Farbprüffolie und Verfahren zu ihrer Herstellung**
Colour-proofing sheet and production process
Feuille pour épreuve en couleurs et procédé de fabrication

(30) Priorität: 18.04.1986 US 853782
(43) Veröffentlichungstag der Anmeldung: 28.10.1987
(73) Patentinhaber: HOECHST CELANESE CORPORATION, Somerville, N.J. 08876 (US)
(72) Erfinder: Platzer, Stephan J.W. Dipl.-Chem., California, N.J. 07830 (US); Yener, Mehmet U. Dipl.-Chem., Rahway, N.Y. 07065 (US); Wanat, Stanley F., Dipl.-Chem., Scotch Plains, N.J. 07076 (US)
(74) Vertreter: Neubauer, Hans-Joachim

(56) Entgegenhaltungen:
- EP-A- 0 159 854
- US-A- 4 303 718
- US-A- 4 376 159
- RESEARCH DISCLOSURE. no. 220, August 1982, HAVANT GB Seite 280 An.: "Protective overcoat for overlay proofing systems"

## Beschreibung

Im Mehrfarbendruck wird im allgemeinen eine Farbprüfung vorgenommen, um die Korrektur der für die Belichtung von Druckplatten verwendeten Farbauszüge zu ermöglichen. Das Prüfbild muß ein getreues Abbild des gewünschten Raster- oder Strichbildes sein und soll den Tonwert der Farben weder erhöht noch herabgesetzt wiedergeben. Die visuelle Farbprüfung soll folgendes aufzeigen:
1. Fehler in der Photomaske,
2. die beste Farbwiedergabe, die beim Drucken in der Druckmaschine von dem Material zu erwarten ist,
3. die genaue Gradation aller Farbtöne und ob die Grautöne neutral sind,
4. die eventuelle Notwendigkeit zur Abschwächung einer der Farben und/oder Hinweise zur Änderung der Filmvorlage vor der Herstellung der Druckplatten.
   Die Farbprüfung für den Mehrfarbendruck wird bisher mit Hilfe von Farbandrucken vorgenommen. Dabei müssen alle auch beim tatsächlichen Mehrfarbendruck notwendigen Schritte unternommen werden. Ein solches Farbprüfverfahren ist kostspielig und zeitaufwendig, und man hat deshalb alternative Farbprüfverfahren entwickelt, die den Andrucken in der Qualität gleichkommen sollen. Zwei photographische Farbprüfverfahren sind bekannt, nämlich das sogenannte Surprint-Verfahren (Übereinanderkopieren) und das sogenannte Overlay-Verfahren (Übereinanderlegen).

Beim Farbprüfen nach dem Overlay-Verfahren wird auf jeweils einem transparenten Kunststoffträger von jedem Farbauszug für sich ein Teilfarbenbild hergestellt. Zur Herstellung eines Farbprüfsatzes werden dann mehrere solcher mit Teilfarbenbildern versehener Träger übereinander auf ein weißes Blatt gelegt. Das Overlay-Verfahren hat den Nachteil, daß die übereinanderliegenden Kunststoffträger das Mehrfarbenbild dunkler machen.

Bei der Prüfung nach dem Surprint-Verfahren wird ein Farbprüfbild angefertigt, indem nacheinander Bilder in verschiedenen Farben von verschiedenen Farbauszügen auf einem einzigen Empfangsblatt hergestellt werden. Dazu wird nur ein undurchsichtiger Träger verwendet, auf den nacheinander Toner oder lichtempfindliche Schichten in den entsprechenden Farben aufgebracht werden, wie es zum Beispiel in der US-A 3 671 236 beschrieben ist. Das Surprint-Verfahren hat den Vorteil, daß die Farbsättigung nicht durch übereinanderliegende Kunststoffträger beeinflußt wird. Dieses Verfahren kommt dem tatsächlichen Druck näher und vermeidet die dem Overlay-Verfahren eigene Farbverfälschung.

In der US-A 3 721 557 wird ein Verfahren zur Übertragung von Farbbildern beschrieben, bei dem zwischen der lichtempfindlichen Schicht und dem Träger eine Abziehschicht aufgebracht ist. Wenn die lichtempfindliche Schicht belichtet und entwickelt wird, werden die löslicheren Teile der Schicht selektiv entfernt, und es entsteht ein sichtbares Bild. Der Träger mit dem Bild wird gegen ein geeignetes klebstoffbeschichtetes Empfangsmaterial gepreßt und dann die Bildübertragung durch Abziehen des Trägers vorgenommen. Für jede weitere Bildübertragung wird eine frische Klebstoffschicht auf das Empfangsmaterial aufgetragen.

Ein Nachteil dieser Surprint-Farbprüfverfahren besteht darin, daß das Bild durch äußere Einflüsse, wie z. B. Fingerabdrücke, Kratzer, Staub usw. sehr leicht beschädigt wird.

Zum Schutz der Oberfläche des Surprint-Farbprüfbilds kann daher z. B. eine dünne transparente Folie, beispielsweise aus Polyester, die mit einer druckempfindlichen Klebstoffschicht beschichtet ist, auf die Bildschicht laminiert werden. Ein solches Verfahren ist in der US-A 4 329 420 beschrieben. Dieses bekannte Verfahren führt in der Regel zur Ausbildung von dicken, glänzenden Oberflächenschichten auf der Surprint-Vorlage, durch die das Aussehen der Vorlage unter Umständen nachteilig verändert wird. So soll in vielen Fällen die Oberfläche eines Mehrschichtfarbprüfbogens bevorzugt eine matte, bzw. glanzfreie Struktur aufweisen, um den Druckbedingungen bei der praktischen Anwendung, wo ja weder eine natürliche noch eine durch Beschichtung erzeugte glänzende Oberfläche vorhanden ist, möglichst nahezukommen. Auch ist es nach diesem Verfahren nicht möglich, größere Höhenunterschiede der Bildschicht auszugleichen, wenn man nicht durch Temperatur- und/oder Druckerhöhung beim Laminieren Gefahr laufen will, die Bildelemente zu verzerren.

Es wurde auf verschiedene Weise versucht, den Oberflächenglanz der vorstehend beschriebenen Surprint-Farbprüfvorlagen herabzusetzen, doch war keines der dafür eingesetzten Verfahren einfach und effektiv genug. Das Auftragen von Pigmentpudern, Pigmentsprays, Pigmentlacken oder wäßrigen Pigmentdispersionen auf die glänzende Oberfläche der Vorlage, wie es z. B. in der US-A 4 286 046 beschrieben ist, bringt Probleme hinsichtlich der Kosten, Sauberkeit, und Gesundheit mit sich, und es ist überdies nicht möglich, auf diese Art eine matte Oberfläche zu erzielen, die in Bezug auf Gleichmäßigkeit, Struktur und Aussehen zufriedenstellende Eigenschaften aufweist.

Aufgabe der Erfindung war es, eine Farbprüffolie vorzuschlagen, deren Bildschicht wirksam gegen mechanische und chemische Einflüsse durch eine Schutzschicht geschützt ist, die nach Belieben so dünn gemacht werden kann, daß sie den Bildeindruck nicht verfälscht und die eine ebene, nach Wunsch mattierte oder glänzende Oberfläche aufweist, ohne daß die Bildschicht durch das Aufbringen der Schutzschicht verzerrt oder verändert wird.

Die Erfindung geht aus von einer Farbprüffolie aus einem Schichtträger, einer mehrfarbigen Bildschicht, die aus mehreren Teilfarbenbildern besteht, und einer transparenten Deckschicht.

Die erfindungsgemäße Farbprüffolie ist dadurch gekennzeichnet, daß die Deckschicht aus einer unteren Lage aus einer thermoplastischen Haftschicht, die bei Raumtemperatur nicht klebrig ist und mindestens ein thermoplastisches Polymeres enthält, und einer oberen Lage aus einer Antiblockierschicht besteht, die bei Temperaturen bis zu 50° C nicht blockt und mindestens ein organisches Polymeres enthält.

Erfindungsgemäß wird ferner ein Verfahren zur Herstellung einer Farbprüffolie vorgeschlagen, bei dem auf einen flexiblen Schichtträger nacheinander mehrere Teilfarbenbilder übertragen werden, so daß ein mehrfarbiges Bild entsteht, und das mehrfarbige Bild mit einer transparenten Deckschicht abgedeckt wird.

Das erfindungsgemäße Verfahren ist dadurch gekennzeichnet, daß man auf das mehrfarbige Bild entweder
a) ein mehrlagiges Schichtgebilde aus
   aa) einer Trägerfolie,
   ab) einer transparenten Antiblockierschicht, die bei Temperaturen bis zu 50° C nicht blockt und mindestens ein organisches Polymeres enthält, und
   ac) einer thermoplastischen transparenten Haftschicht, die bei Raumtemperatur nicht klebrig ist und mindestens ein thermoplastisches Polymeres enthält,
   mit der freien Oberfläche der thermoplastischen Haftschicht laminiert und danach die Trägerfolie von der Antiblockierschicht abzieht oder
b) ein Schichtgebilde aus
   ba) einer Trägerfolie und
   bb) einer thermoplastischen transparenten Haftschicht, die bei Raumtemperatur nicht klebrig ist und mindestens ein thermoplastisches Polymeres enthält,
      mit der freien Oberfläche der Haftschicht laminiert, die Trägerfolie von der Haftschicht abzieht, auf die Haftschicht ein Schichtgebilde aus
   bc) einer Trägerfolie und
   bd) einer transparenten Antiblockierschicht, die bei Temperaturen bis zu 50° C nicht blockt und mindestens ein organisches Polymeres enthält,
   mit der freien Oberfläche der Antiblockierschicht laminiert und die Trägerfolie von der Antiblockierschicht abzieht.

Unter "Blocken" oder "Blockieren" soll im Rahmen dieser Beschreibung die bekannte Neigung thermoplastischer Folien oder Schichten verstanden werden, bei längerer Lagerung im direkten Kontakt aneinander zu haften.

Die thermoplastische Haftschicht soll bei Raumtemperatur nicht klebrig sein, jedoch bei Temperaturen zwischen 60 und 90° C unter dem Druck der Laminierung eine feste Haftung sowohl zu der Bildschicht als auch zu der Antiblockierschicht ausbilden.

Zur Durchführung des erfindungsgemäßen Verfahrens wird ein lichtempfindliches Material eingesetzt, das generell aus einem Schichtträger und einem darauf erzeugten Farbbild besteht und an sich bekannt ist.

In bevorzugter Ausführung besteht der Schichtträger aus einer maßbeständigen und chemisch stabilen Polyesterfolie, insbesondere aus Polyethylenterephthalat, die normalerweise eine Dicke von etwa 25 - 250 µm, vorzugsweise etwa 50 - 130 µm und insbesondere etwa 50 - 75 µm aufweist. Geeignete Folien sind zum Beispiel Hostaphan 3000 (Hersteller American Hoechst Corporation), Mylar D (Hersteller DuPont) und Melinex in den Qualitäten 0, 052, 442, 516 und S (Hersteller ICI).

Auf der Trägeroberfläche ist ein farbiges Bild verankert. Dieses Gesamtbild besteht bevorzugt aus vier Einzelbildern je einer Grundfarbe, die übereinanderlaminiert sind, so daß eine farbgetreue Wiedergabe einer Bildvorlage erhalten wird. In der Regel wird jedes Einzelbild aus einem farbigen lichtempfindlichen Material durch bildmäßiges Belichten und Entwickeln hergestellt.

Im allgemeinen besteht die lichtempfindliche Schicht des lichtempfindlichen Materials aus einer lichtempfindlichen Verbindung, einem Farbmittel, einem Harz als Bindemittel und gegebenenfalls weiteren Bestandteilen, z. B. Weichmachern, sauren Stabilisatoren, Tensiden, Antistatika, UV-Absorbern und Lösemittelresten.

Als lichtempfindliche Verbindungen sind u. a. Chinondiazide geeignet, z. B. Ester von 1,2-Naphthochinon-2-diazid-5-sulfonsäure und mehrwertigen Phenolen, z. B. 2,3,4-Trihydroxy-benzophenon oder dem Umsetzungsprodukt von 2 mol dieser Verbindung mit 1 mol Formaldehyd. Derartige Verbindungen sind in den US-A 4 407 426, 4 266 001 und 3 201 239 beschrieben.

Als lichtempfindliche Verbindung wird vorzugsweise ein Diazoniumsalz-Polykondensationsprodukt verwendet. Am meisten bevorzugt wird ein Polykondensationsprodukt aus 3-Methoxy-diphenylamin-4-diazoniumsulfat und 4,4′-Bis-methoxymethyl-diphenylether, ausgefällt als Mesitylensulfonat, wie in der US-A 3 849 392 beschrieben. Weitere geeignete Verbindungen sind in der US-A 4 436 804 genannt. Die gewählten Diazoniumverbindungen sind bevorzugt in organischen Lösemitteln löslich.

Als Bindemittel geeignete Harze sind Polyvinylbutyral und Styrol/Maleinsäurehalbester-Copolymeren oder Mischungen daraus. Solche Harze sind beispielsweise Butvar B 72, B 76 und B 90 und Scripset 540 bzw. 550, die alle von Monsanto hergestellt werden. Ein wichtiges Kriterium bei der Wahl des Harzes ist, daß es gute Filmbildungseigenschaften haben muß.

Zu den erfindungsgemäß geeigneten Farbmitteln zählen verschiedene Farbstoffe und Pigmente. In der am meisten bevorzugten Ausführung werden Pigmente mit einer durchschnittlichen Teilchengröße von höchstens etwa 1 µm eingesetzt.

Der lichtempfindlichen Schicht können gegebenenfalls Weichmacher vom Phthalat- oder Phosphattyp zugesetzt werden. Bevorzugte Weichmacher sind Dibutylphthalat und Dimethylphthalat. Geeignete saure Stabilisatoren sind zum Beispiel Phosphorsäure und p-Toluolsulfonsäure.

Diese Komponenten können in verträglichen Lösemitteln wie Ethanol, 2-Methoxy-ethanol, Diacetonalkohol, Butyrolacton, Propylenglykolmonomethylether oder Butanon gelöst auf die Trägeroberfläche aufgetragen und getrocknet werden.

Die lichtempfindliche Schicht wird vorzugsweise mit Hilfe eines geeigneten Klebstoffs, z. B. Polyvinylacetat, auf dem Träger verankert.

Durch die Erfindung soll das auf den Träger aufgebrachte Bild vor gebrauchs- und transportbedingten Beschädigungen durch Kratzer, Schmutzpartikel u. dgl. geschützt werden.

Zu diesem Zweck soll die Bildschicht eine dünne, dauerhafte Schutzschicht erhalten. Dicke Schutzschichten können zwar leicht aufgetragen werden, sie verzerren jedoch die optischen Eigenschaften des Bildes. Wenn eine dicke Schutzschicht unter Anwendung von Wärme und Druck auf die Bildschicht laminiert wird, kommt es allen Fällen, wo die thermische Ausdehnung der Schutzschicht verschieden ist von der thermischen Ausdehnung des Verbundes aus Bildschicht und Trägermaterial, zu einer beträchtlichen Verkrümmung der mit der Schutzschicht versehenen Bildschicht.

Es wird daher angestrebt, die Laminierung unter Anwendung von Druck und bei relativ geringer Temperatur vorzunehmen, da bei zu hohen Temperaturen die Gefahr besteht, daß das Bild sich verformt und verfärbt. Außerdem darf die Schutzschicht auch bei längerer Lagerung nicht blocken.

Erfindungsgemäß wird das Bild durch eine direkt auf die Bildoberfläche laminierte Klebstoffschicht und eine auf die Oberfläche der Klebstoffschicht aufgebrachte Antiblockschicht geschützt. Für den Auftrag dieser beiden Schichten gibt es zwei Vorgehensweisen:

Die Klebstoff- und die Antiblockierschicht können einzeln oder gemeinsam aufgetragen werden. Beim Einzelauftrag müssen sich die beiden Schichten nach dem Laminieren von ihren jeweiligen temporären Trägerfolien lösen, d.h. die Haftkraft zwischen der Klebstoffschicht bzw. der Antiblockierschicht und der jeweiligen Trägerfolie muß geringer sein als die Haftkraft zwischen der Bildschicht und der Klebstoffschicht bzw. zwischen der Klebstoffschicht und der Antiblockierschicht. Sie muß auch geringer sein als die Kohäsion von Bildschicht, Klebstoffschicht, Antiblockierschicht und Trägerfolie. Die auf eine Trägerfolie aufgebrachte Klebstoffschicht kann zunächst auf die ebenfalls auf eine Trägerfolie aufgebrachte Antiblockierschicht laminiert und anschließend kann die Trägerfolie der Klebstoffschicht abgezogen werden. Nach dem Laminieren muß die Haftung zwischen der Klebstoffschicht und ihrer Trägerfolie geringer sein als die Haftung zwischen der Antiblockierschicht und ihrer Trägerfolie. Der Verbund aus Klebstoffschicht, Antiblockierschicht und Trägerfolie wird dann auf die Bildschicht laminiert, und zwar so, daß die Klebstoffschicht direkt auf die Bildschicht appliziert wird. Anschließend wird die Trägerfolie der Antiblockierschicht abgezogen.

Bevorzugt befinden sich die Klebstoffschicht und die Antiblockierschicht auf einer gemeinsamen Trägerfolie. Dabei grenzt die Antiblockierschicht an die Trägerfolie an. Sie muß sich nach dem Laminieren von der Trägerfolie lösen lassen. Die Haftkraft zwischen der Antiblockierschicht und der Trägerfolie muß geringer sein als die Haftkraft zwischen der Klebstoffschicht und der Antiblockierschicht und auch geringer als die Haftkraft zwischen der Klebstoffschicht und der Bildschicht.

Auf den einzelnen Klebstoff- und Antiblockierschichten können sich zum Schutz gegen Verschmutzung Schutzfolien befinden, die vor dem Laminiervorgang abgezogen werden. Dabei muß die Haftkraft zwischen der Klebstoff- bzw. Antiblockierschicht und der jeweiligen Schutzfolie geringer sein als die Haftkraft zwischen der Klebstoff-bzw. Antiblockierschicht und der jeweiligen Trägerfolie. Bevorzugt wird die Klebstoffschicht des auf eine Trägerfolie aufgebrachten Verbunds aus Klebstoff-und Antiblockierschicht mit der Schutzfolie abgedeckt. Vor dem Laminieren des Verbunds auf die Bildschicht wird die Schutzfolie abgezogen.

Die Trägerfolien bestehen vorzugsweise aus einem Material, das unter Laminierbedingungen formstabil bleibt, z. B. aus Polyester, insbesondere Polyethylenterephthalat. Sie können transparent oder opak, farblos oder farbig sein.

Die Oberfläche des Trägers kann glatt oder matt strukturiert sein. Entsprechende Mattierungsverfahren sind aus dem Stand der Technik bekannt.

Als glatte Trägerfolie eignet sich beispielsweise Folie des Typs Melinex 516, Hersteller ICI.

Zu den geeigneten mattierten Folien zählen Melinex 329, 377 und 470. Der Oberflächenglanz des endgültigen Bildes kann durch die Wahl einer entsprechend mattierten Trägerfolie für die Antiblockierschicht bestimmt werden.

Zur Erzeugung einer matten Schutzschicht werden die Klebstoff- und die Antiblockierschicht unter Druck und Wärme auf das fertige Bild laminiert. Dann wird die Trägerfolie mit der aufgerauhten Oberfläche abgezogen. Durch die rauhe Oberfläche der Trägerfolie erhält das fertige Bild eine matte Schutzschicht. Die Oberflächenstruktur der solchermaßen geschützten Bildschicht kann durch das nachfolgende Auflaminieren einer strukturierten Folie, die im Anschluß an den Laminiervorgang wieder abgezogen wird, noch weiter modifiziert werden. Die weitere Modifizierung kann auch durch eine Behandlung mit Lösemitteln und/oder Schleifpartikeln erfolgen, durch die ein Teil der Schutzschicht wieder abgetragen wird.

In allen Fällen muß die Trägerfolie eine nichthaftende Oberfläche besitzen, d.h. die Antiblockierschicht muß ablösbar auf ihr verankert werden können. Dies wird dadurch erreicht, daß eine Trägerfolie verwendet wird, deren Oberfläche von Natur aus nichthaftend ist, oder daß die Trägeroberfläche durch eine entsprechende Behandlung, bzw. durch das Auftragen einer speziellen Trennschicht nichthaftend gemacht wird. Solch eine Trennschicht kann beispielsweise aus Polyvinylalkohol bestehen.

Die Klebstoffschicht hat eine Dicke von 0,5 bis 30 µm, bevorzugt von 1 bis 20 µm, und insbesondere von 5 bis 20 µm.

Die Klebstoffschicht besteht in der Hauptsache aus einem thermoplastischen Polymeren, bzw. aus einem Gemisch thermoplastischer Polymerer, das bei Zimmertemperatur praktisch nicht klebrig ist. Geeignete Polymere besitzen eine Glastemperatur Tg von 20 bis 60 °C, insbesondere von 25 bis 55 °C. Die thermoplastischen Polymeren sollten zur Ausbildung flexibler Schichten befähigt sein. Sie sind transparent und farblos. Die Klebstoffschicht kann außerdem Weichmacher, UV-Absorber, Netzmittel und Antistatika enthalten.

Zu den geeigneten thermoplastischen Klebstoffen zählen Polyvinylacetale, wie Butvar B 79, Hersteller Monsanto; Polyvinylacetate, wie Mowilith 30, Hersteller American Hoechst Corp.; Polybutylmethacrylate, wie Elvacite 2044, Hersteller DuPont; Cellulosenitrate, wie RS ½, Hersteller Hercules; und Polyvinylchlorid/Polyvinylacetat-Copolymere, wie UCAR VYNC, Hersteller UCC. Auch Novolake und Epoxyharze können eingesetzt werden.

Die Dicke der Antiblockierschicht beträgt 0,2 bis 20 µm, bevorzugt 1 bis l0 µm, insbesondere 1 bis 3 µm. Diese Schicht besteht überwiegend aus einem organischen Polymeren, bzw. aus einem Gemisch organischer Polymerer. Die Zusammensetzung der Antiblockierschicht wird so gewählt, daß sie bei Temperaturen bis maximal 50 °C, bevorzugt bis 70 °C, nicht blockt. Das Blocken wird nach bekannten Normvorschriften gemessen, z. B. mit Hilfe des in ASTM D 1146 beschriebenen Verfahrens.

Die in der Antiblockierschicht verwendeten Polymeren sollten eine Glastemperatur über 60 °C, bevorzugt über 70 °C, und insbesondere über 100 °C besitzen. Sie sollten zur Ausbildung flexibler Schichten befähigt sein. Auch sie sind transparent und farblos; sie können Zusätze, wie Weichmacher, UV-Absorber, Netzmittel und Antistatika enthalten. Ein geeigneter polymerer Weichmacher ist z. B. Carboset 525, ein Acrylharz der B.F. Goodrich Company.

Als Polymere mit Antiblockiereigenschaften sind z. B. Styrol/Maleinsäureanhydrid-Copolymere, wie Scripset 540, Hersteller Monsanto; Polyvinylacetale, wie Butvar B 90, Hersteller Monsanto; Polymethylmethacrylate, wie Elvacite 2008, Hersteller DuPont; und Vinylacetat/Vinylchlorid-Copolymere, wie Hostaflex CM 131, Hersteller American Hoechst Corp. geeignet.

Die Antiblockierschicht und die Klebstoffschicht werden in bekannter Weise, z. B. durch Beschichten oder Laminieren, auf die entsprechenden temporären Trägerfolien aufgebracht.

Das Laminieren des Verbunds aus Trägerfolie, Antiblockierschicht und Klebstoffschicht auf das Bild, bzw. das Laminieren des Verbunds aus Trägerfolie und Klebstoffschicht auf das Bild und das anschließende Laminieren des Verbunds aus Träger und Antiblockierschicht erfolgt unter Druck und Wärme.

Für den Laminiervorgang wird beispielsweise das Bild in Kontakt mit der Klebstoffschicht des Verbunds gebracht, und die beiden Teile werden anschließend durch den Walzenspalt eines Paars beheizter Laminierwalzen geführt, durch das ein angemessener Druck ausgeübt wird. Die Laminiertemperaturen liegen im allgemeinen im Bereich von 60 bis 90 °C, bevorzugt im Bereich von 75 bis 85 °C. Nach dem Laminieren wird die Trägerfolie abgezogen, was in der Regel manuell erfolgt. Die Klebstoffschicht und die Antiblockierschicht bleiben dabei auf dem bebilderten Träger zurück.

Anhand der folgenden Beispiele wird die Erfindung näher erläutert. Alle Schichtgewichte gelten darin für trockene Schichten.

### Beispiel 1

Zur Herstellung einer Antiblockiermischung werden die folgenden Bestandteile nacheinander in ein Gefäß gegeben:
39 % Ethylenglykolmonomethylether,
39 % Methylethylketon,
10 % Butyrolacton,
10 % Scripset 540 (Styrol/Monoisobutylmaleinat-Copolymeres; Säurezahl 185; Mₙ 50.000; Tg = 133 °C) und
2 % Carboset 525 (Terpolymeres aus 32 % Ethylacrylat, 58 % Methylmethacrylat, 10 % Acrylsäure; SZ 80; MG 260.000)
Das zweite Polymere wird erst zugegeben, wenn das erste Polymere vollständig gelöst ist. Die Lösung wird mindestens eine Stunde gerührt, bis alle Bestandteile gelöst sind. Dann wird sie auf eine 0,076 mm dicke Polyesterfolie mit matter, unbehandelter Oberfläche (Melinex 377) so aufgetragen, daß ein Trockenschichtgewicht von 3 g/m² resultiert. Die Schicht wird bei 85 °C eine Minute trockengeblasen.
Zur Herstellung einer Klebstofflösung werden die folgenden Bestandteile nacheinander in ein sauberes Gefäß gegeben:
50 % n-Butylacetat und
50 % UCAR VYNC (Vinylchlorid/Vinylacetat-Copolymeres) in Isopropylacetat (Tg = 51° C, Hersteller UCC).

Die Lösung wird mindestens eine Stunde bei Zimmertemperatur gerührt und dann zu einem Trockenschichtgewicht von 12 g/m² auf die Antiblockierschicht aufgetragen. Der so auf der Trägerfolie entstandene Verbund wird 90 Sekunden bei 85 °C getrocknet. Anschließend wird er mit der Klebstoffschicht direkt auf eine vierfarbige Bildschicht plaziert. Das Laminieren erfolgt, indem die beiden aufeinandergelegten Materialien unter entsprechendem Druck durch den Walzenspalt eines auf 75° C aufgeheizten Laminierwalzenpaares geführt werden. Nach dem Laminieren wird die Trägerfolie abgezogen. Dabei bleiben die Klebstoff- und die Antiblockierschicht auf der vierfarbigen Bildschicht zurück. Durch die Polyesterfolie hat die Oberfläche der Antiblockierschicht eine rauhe Struktur erhalten. Bei einer Belastung mit 0.07 kg/cm² und einer Temperatur von 70° C wird auch nach 24 Stunden kein Blocken festgestellt.

### Beispiel 2

Zur Herstellung einer Antiblockiermischung werden die folgenden Bestandteile nacheinander in ein Gefäß gegeben:
42 % Ethylenglykolmonomethylether,
42 % Methylethylketon,
10 % Butyrolacton und
6 % Butvar B-90 (Polyvinylbutyral; Tg = 65° C).

Die Lösung wird mindestens drei Stunden gerührt, bis das Polymere vollständig gelöst ist. Dann wird sie auf eine 0,076 mm dicke hochtransparente Polyesterfolie mit glatter, unbehandelter Oberläche (Melinex 516) so aufgetragen, daß ein Trockenschichtgewicht von 1 g/m² resultiert. Die Schicht wird bei 85° C eine Minute getrocknet.

Zur Herstellung einer Klebstofflösung werden die folgenden Bestandteile nacheinander in ein sauberes Gefäß gegeben:
78 % n-Butylacetat,
21 % Mowilith 30 (Polyvinylacetat, MG 110.000; Tg = 28° C) und
1 % Resoflex R 296.

Die Lösung wird mindestens vier Stunden bei Zimmertemperatur gerührt und dann zu einem Trockenschichtgewicht von 10 g/m² auf die Antiblockierschicht aufgetragen und 90 Sekunden bei 85° C getrocknet. Zum Schutz gegen Verschmutzung wird die Klebstoffschicht mit einem Zwischenlagenpapier Nr. 7 der Firma Bauer abgedeckt, das vor dem Laminieren wieder abgezogen wird. Für den Laminiervorgang wird der auf die Trägerfolie aufgetragene Schutzschichtenverbund mit der Klebstoffseite direkt auf eine vierfarbige Bildschicht plaziert. Das Laminieren erfolgt, indem die beiden aufeinandergelegten Materialien unter entsprechendem Druck durch den Walzenspalt eines auf 75 °C aufgeheizten Laminierwalzenpaares geführt werden. Nach dem Laminieren wird die Trägerfolie abgezogen. Dabei bleiben die Klebstoff-und die Antiblockierschicht auf der vierfarbigen Bildschicht zurück. Durch die Polyesterfolie hat die Oberfläche der Antiblockierschicht eine glänzende Oberfläche erhalten. In einem weiteren Schritt wird auf die Antiblockierschicht des Verbunds aus Antiblockier-, Klebstoff- und Bildschicht eine Polyesterfolie des in Beispiel 1 verwendeten Typs (Melinex 377) laminiert und anschließend wieder abgezogen. Dadurch erhält die Oberfläche der Schutzschicht ein halbmattes Aussehen. Ein Blocken der mit der Schutzschicht versehenen Bildschicht wird auch bei 50 °C nicht festgestellt.

### Beispiel 3

Nach den Angaben von Beispiel 1 wird auf eine Bildschicht eine Schutzschicht aufgebracht. Das Material wird anschließend flach in eine Schale gelegt. Ein normalerweise zum Entwickeln verwendeter Baumwolltampon wird mit einer wäßrigen Natriumhydroxidlösung, deren pH-Wert 12,5 beträgt, getränkt. Die geschützte Bildschicht wird unter leichtem Druck mit dem vollgesogenen Tampon abgerieben, um so die Antiblockierschicht teilweise zu entfernen. Anschließend wird die geschützte Bildschicht 20 Sekunden mit Wasser abgespült, auf nichtfaserndes Papier gelegt und trockengetupft. Durch die Behandlung mit der Natriumhydroxidlösung und das anschließende Abspülen mit Wasser wurde die rauhe Struktur der Antiblockierschichtoberfläche teilweise entfernt.

### Beispiel 4

Nach den Angaben von Beispiel 1 wird auf einer Trägerfolie ein Verbund aus Klebstoff- und Antiblockierschicht hergestellt. Eine vierfarbige Bildschicht wird nach den Angaben der US-A 3 671 236 erzeugt. Der Verbund wird mit der Klebstoffseite auf die Bildschicht gelegt, und die beiden Materialien werden bei einer Temperatur von 75 °C und unter entsprechendem Druck zwischen einem beheizten Laminierwalzenpaar hindurchgeführt und dabei aufeinander laminiert. Anschließend wird die Trägerfolie abgezogen. Die Klebstoff- und die Antiblockierschicht bleiben auf der vierfarbigen Bildschicht zurück.

### Beispiel 5

Zur Herstellung einer Antiblockierschicht werden die folgenden Komponenten nacheinander in ein Gefäß gegeben:
85 % Methylethylketon und
15 % Hostaflex CM 131 (Vinylchlorid/Vinylacetat-Copolymeres; Tg = 75 °C)
Die Lösung wird mindestens drei Stunden bei Raumtemperatur gerührt, bis die Komponenten vollständig gelöst sind. Dann wird sie mit einem Rakel auf eine 0,076 mm dicke hochgeschmeidige Polyesterfolie mit unbehandelter Oberfläche (Melinex 470) so aufgetragen, daß ein Trockenschichtgewicht von 3 g/m² erhalten wird. Die Trocknung erfolgt bei 100 °C während einer Minute.

Zur Herstellung der Klebstoffschicht wird eine Lösung der nachstehend angegebenen Zusammensetzung mittels eines Rakels auf eine 0,1 mm dicke hochtransparente Polyesterfolie, deren Oberfläche mit einem Gleitmittel behandelt worden ist (Hostaphan 3000), aufgetragen. Die Beschichtung hat ein Gewicht von 18 g/m².
78 % n-Butylacetat,
21 % Mowilith 30 und
1 % Resoflex R296.

Die Beschichtung wird 3 Minuten bei 100 °C getrocknet. Anschließend wird die Folie mit der Klebstoffseite direkt auf eine vierfarbige Bildschicht laminiert, indem die beiden Materialien bei 75 °C und unter entsprechendem Druck durch den Walzenspalt eines beheizten Laminierwalzenpaares geführt werden. Nach Laminierung wird die Trägerfolie von der Klebstoffschicht abgezogen. Die Antiblockierschicht wird wie vorstehend beschrieben direkt auf die Klebstoffschicht laminiert. Anschließend wird die Trägerfolie der Antiblockierschicht abgezogen, so daß nur die Klebstoff- und die Antiblockierschicht auf der vierfarbigen Bildschicht zurückbleiben. Durch die Melinex 470-Folie hat die Oberfläche der Antiblockierschicht eine feine Struktur erhalten. Bei 50 °C wird noch kein Blocken der geschützten Bildschicht festgestellt.

### Beispiel 6

Es wird verfahren wie in Beispiel 1, außer daß die eingesetzte Klebstoffschicht folgende Zusammensetzung hat:
64 % n-Butylacetat,
10 % Mowilith 30,
1 % Resoflex R296 und
25 % UCAR VYNC in Isopropylacetat.

Die Ergebnisse entsprechen denen von Beispiel 1.

### Beispiel 7

Es wird verfahren wie in Beispiel 1, außer daß die eingesetzte Antiblockierschicht folgende Zusammensetzung hat:
9 % Butyrolacton,
35 % Methylethylketon,
34 % Ethylenglykolmonomethylether,
8 % Scripset 540,
2 % Carboset 525 und
11 % n-Butylacetat.

Bei 70 °C wird noch kein Blocken der geschützten Bildschicht festgestellt.

### Beispiel 8

Es wird verfahren wie in Beispiel 1, außer daß das Schichtgewicht der Antiblockierschicht 5 g/m² und das der Klebstoffschicht 11 g/m² beträgt. Die Ergebnisse entsprechen denen von Beispiel 1.

### Beispiel 9

Zur Herstellung einer Antiblockierschicht werden die folgenden Bestandteile der Reihe nach miteinander vermischt:
20 % Methylethylketon,
67 % n-Butylacetat,
12 % Hostaflex CM 131 und
1 % Resoflex R296.

Die Lösung wird mindestens 3 Stunden bei Zimmertemperatur gerührt, bis alle Bestandteile vollständig gelöst sind. Dann wird sie mittels eines Rakels auf eine Melinex 377-Folie aufgetragen. Das erhaltene Schichtgewicht beträgt 5 g/m². Die Beschichtung wird eine Minute bei 85 °C getrocknet.

Zur Herstellung einer Klebstoffschicht wird eine Lösung der nachstehend angegebenen Zusammensetzung mit Hilfe eines Rakels auf eine Folie des Typs Melinex 516 aufgetragen. Das Schichtgewicht beträgt 12 g/m².
78 % n-Butylacetat,
21 % Mowilith 30 und
1 % Resoflex R296.

Die Schicht wird 90 Sekunden bei 85 °C getrocknet. Dann wird die Folie mit der Klebstoffseite direkt auf eine vierfarbige Bildschicht laminiert, indem die beiden Materialien bei 75 °C und unter entsprechendem Druck durch den Walzenspalt eines beheizten Laminierwalzenpaares geführt werden. Nach erfolgter Laminierung wird die Trägerfolie von der Klebstoffschicht abgezogen. Die Antiblockierschicht wird wie vorstehend beschrieben direkt auf die Klebstoffschicht lamminiert. Anschließend wird die Trägerfolie der Antiblockierschicht abgezogen, so daß nur die Klebstoff- und die Antiblockierschicht auf der vierfarbigen Bildschicht zurückbleiben. Durch die Melinex 377-Folie hat die Oberfläche der Antiblockierschicht eine rauhe Struktur erhalten.

### Beispiel 10

Es wird verfahren wie in Beispiel 9, außer daß die Antiblockierschicht auf eine Folie des Typs Melinex 516 aufgetragen wird. Es werden vergleichbare Ergebnisse erzielt, doch verleiht die Folie der Oberfläche der Antiblockierschicht ein glänzendes Aussehen.

### Beispiel 11

Es wird verfahren wie in Beispiel 1, außer daß die Folie mit einer Antiblockierschicht der nachstehend angegebenen Zusammensetzung beschichtet wird und das Schichtgewicht 5 g/m² beträgt.
65 % n-Butylacetat,
20 % Methylethylketon,
1 % Resoflex R296,
0.4% Mowilith 30 und
13.6% Hostaflex CM 131.

Auf die Antiblockierschicht wird eine Klebstofflösung der nachstehend angegebenen Zusammensetzung aufgetragen. Das Schichtgewicht beträgt 12 g/m².
79 % n-Butylacetat,
1 % Resoflex R296 und
20 % Mowilith 30.

Der Schichtverbund wird auf ein Mehrfarbenbild laminiert und die Trägerfolie abgezogen. Bei einer Temperatur von 50 °C wird noch kein Blocken festgestellt.

## Patentansprüche

1. Farbprüffolie aus einem Schichtträger, einer mehrfarbigen Bildschicht, die aus mehreren Teilfarbenbildern besteht, und einer transparenten Deckschicht, dadurch gekennzeichnet, daß die Deckschicht aus einer unteren Lage aus einer thermoplastischen Haftschicht, die bei Raumtemperatur nicht klebrig ist und mindestens ein thermoplastisches Polymeres enthält, und einer oberen Lage aus einer Antiblockierschicht besteht, die bei Temperaturen bis zu 50° C nicht blockt und mindestens ein organisches Polymeres enthält.

2. Farbprüffolie nach Anspruch 1, dadurch gekennzeichnet, daß die äußere Oberfläche der Antiblockierschicht mattiert ist.

3. Farbprüffolie nach Anspruch 1, dadurch gekennzeichnet, daß die Antiblockierschicht eine Glastemperatur (Tg) von mindestens 60° C hat.

4. Farbprüffolie nach Anspruch 1, dadurch gekennzeichnet, daß die Haftschicht eine Glastemperatur (Tg) von 20 bis 60° C hat.

5. Farbprüffolie nach Anspruch 1, dadurch gekennzeichnet, daß die Antiblockierschicht eine Dicke von 0,5 bis 20 µm hat.

6. Farbprüffolie nach Anspruch 1, dadurch gekennzeichnet, daß die thermoplastische Haftschicht eine Dicke von 1 bis 20 µm hat.

7. Farbprüffolie nach Anspruch 1, dadurch gekennzeichnet, daß die äußere Oberfläche der Antiblockierschicht eben ist.

8. Verfahren zur Herstellung einer Farbprüffolie, bei dem auf einen flexiblen Schichtträger nacheinander mehrere Teilfarbenbilder übertragen werden, so daß ein mehrfarbiges Bild entsteht, und das mehrfarbige Bild mit einer transparenten Deckschicht abgedeckt wird, dadurch gekennzeichnet, daß man auf das mehrfarbige Bild entweder
a) ein mehrlagiges Schichtgebilde aus
aa) einer Trägerfolie,
ab) einer transparenten Antiblockierschicht, die bei Temperaturen bis zu 50° C nicht blockt und mindestens ein organisches Polymeres enthält, und
ac) einer thermoplastischen transparenten Haftschicht, die bei Raumtemperatur nicht klebrig ist und mindestens ein thermoplastisches Polymeres enthält,
mit der freien Oberfläche der thermoplastischen Haftschicht laminiert und danach die Trägerfolie von der Antiblockierschicht abzieht oder
b) ein Schichtgebilde aus
ba) einer Trägerfolie und
bb) einer thermoplastischen transparenten Haftschicht, die bei Raumtemperatur nicht klebrig ist und mindestens ein thermoplastisches Polymeres enthält,
mit der freien Oberfläche der Haftschicht laminiert, die Trägerfolie von der Haftschicht abzieht, auf die Haftschicht ein Schichtgebilde aus
bc) einer Trägerfolie und
bd) einer transparenten Antiblockierschicht, die bei Temperaturen bis zu 50° C nicht blockt und mindestens ein organisches Polymeres enthält,
mit der freien Oberfläche der Antiblockierschicht laminiert und die Trägerfolie von der Antiblockierschicht abzieht.

9. Verfahren nach Anspruch 8, dadurch gekennzeichnet, daß man die Laminierung jeweils bei einer Temperatur im Bereich von 60 bis 90° C durchführt.

## Claims

1. Colour-proofing sheet comprising a temporary support, a multi-coloured image layer consisting of a plurality of images in primary colours, and a transparent covering layer, characterized in that the covering layer consists of a lower ply of a thermoplastic adhesive layer which is non-tacky at room temperature and contains at least one thermoplastic polymer, and of an upper ply of an anti-blocking layer which does not block at temperatures of up to 50°C and contains at least one organic polymer.

2. Colour-proofing sheet according to Claim 1, characterized in that the outer surface of the anti-blocking layer has a matte texture.

3. Colour-proofing sheet according to Claim 1, characterized in that the anti-blocking layer has a glass temperature (Tg) of at least 60°C.

4. Colour-proofing sheet according to Claim 1, characterized in that the adhesive layer has a glass temperature (Tg) of from 20 to 60°C.

5. Colour-proofing sheet according to Claim 1, characterized in that the anti-blocking layer has a thickness of from 0.5 to 20 µm.

6. Colour-proofing sheet according to Claim 1, characterized in that the thermoplastic adhesive layer has a thickness of from 1 to 20 µm.

7. Colour-proofing sheet according to Claim 1, characterized in that the outer surface of the anti-blocking layer is plane.

8. Method of preparing a colour-proofing sheet, in which a plurality of images in primary colours are successively transferred to a flexible temporary support in such a way that a multi-coloured image is formed, and the multi-coloured image is covered by a transparent covering layer, characterized in that either
a) a multi-ply layer structure of
aa) a temporary support,
ab) a transparent anti-blocking layer which does not block at temperatures of up to 50°C and contains at least one organic polymer, and
ac) a thermoplastic transparent adhesive layer which is non-tacky at room temperature and contains at least one thermoplastic polymer,
is laminated with the free surface of the thermoplastic adhesive layer to the multi-coloured image and the temporary support is then peeled away from the anti-blocking layer, or
b) a layer structure of
ba) a temporary support and
bb) a thermoplastic transparent adhesive layer which is non-tacky at room temperature and contains at least one thermoplastic polymer is laminated with the free surface of the adhesive layer to the multi-coloured image, the temporary support is peeled away from the adhesive layer, a layer structure of
bc) a temporary support and
bd) a transparent anti-blocking layer which does not block at temperatures of up to 50°C and contains at least one organic polymer,
is laminated with the free surface of the anti-blocking layer to the adhesive layer and the temporary support is peeled away from the anti-blocking layer.

9. Process according to Claim 8, characterized in that the lamination is in each case carried out at a temperature in the range from 60 to 90°C.

## Revendications

1. Feuille pour épreuve en couleurs constituée d'un support pelliculaire, d'une couche de cliché polychrome composée de plusieurs images monochromes, et d'une couche de recouvrement transparente, caractérisée en ce que la couche de recouvrement se compose d'une nappe inférieure constituée d'une couche adhésive thermoplastique, qui n'est pas adhésive à la température ambiante et qui contient au moins un polymère thermoplastique, et d'une nappe supérieure contituée d'une couche antiblocage, qui ne bloque pas à des températures allant jusqu'à 50°C et qui contient au moins un polymère organique.

2. Feuille pour épreuve en couleurs selon la revendication 1, caractérisée en ce que la surface extérieure de la couche antiblocage est dépolie.

3. Feuille pour épreuve en couleurs selon la revendication 1, caractérisée en ce que la couche antiblocage présente une température de transition vitreuse (Tv) valant au moins 60°C.

4. Feuille pour épreuve en couleurs selon la revendication 1, caractérisée en ce que la couche adhésive présente une température de transition vitreuse valant de 20 à 60°C.

5. Feuille pour épreuve en couleurs selon la revendication 1, caractérisée en ce que la couche antiblocage présente une épaisseur valant de 0,5 à 20 µm.

6. Feuille pour épreuve en couleurs selon la revendication 1, caractérisée en ce que la couche adhésive thermoplastique présente une épaisseur valant de 1 à 20 µm.

7. Feuille pour épreuve en couleurs selon la revendication 1, caractérisée en ce que la surface extérieure de la couche antiblocage est lisse.

8. Procédé pour préparer une feuille pour épreuve en couleurs, au cours duquel on dispose successivement plusieurs images monochromes sur un support pelliculaire flexible, de manière à former une image polychrome, et on recouvre l'image polychrome avec une couche de recouvrement transparente, caractérisé en ce que, sur l'image polychrome :
a) on stratifie un produit stratifié multicouche composé de :
aa) une feuille support,
ab) une couche antiblocage transparente, qui ne bloque pas à des températures allant jusqu'à 50°C et qui contient au moins un polymère organique, et
ac) une couche adhésive thermoplastique transparente, qui n'est pas adhésive à la température ambiante et qui contient au moins un polymère thermoplastique,
à l'aide de la surface libre de la couche adhésive thermoplastique, et on retire ensuite la feuille support de la couche antiblocage en la pelant, ou
b) on stratifie un produit stratifié composé de :
ba) une feuille support, et
bb) une couche adhésive thermoplastique transparente, qui n'est pas adhésive à la température ambiante et qui contient au moins un polymère thermoplastique,
à l'aide de la surface libre de la couche adhésive, on retire la feuille support de la couche adhésive en la pelant et, sur la couche adhésive, on stratifie un produit stratifié constitué de :
bc) une feuille support et
bd) une couche antiblocage transparente, qui ne bloque pas à des températures allant jusqu'à 50°C et qui contient au moins un polymère organique,
à l'aide de la surface libre de la couche antiblocage et on retire la feuille support de la couche antiblocage en la pelant.

9. Procédé selon la revendication 8, caractérisé en ce que l'on effectue chaque stratification à une température valant de 60 à 90°C.
